Europäisches Patentamt

European Patent Office

Office européen des brevets

(11) Publication number: **0 345 626 B1**

# EUROPEAN PATENT SPECIFICATION

(45) Date of publication of patent specification: **18.05.94**   (51) Int. Cl.5: **H01L  31/10,** H01L 33/00, H01S 3/103

(21) Application number: **89109880.8**

(22) Date of filing: **01.06.89**

(54) **Optical semiconductor device.**

(30) Priority: **07.06.88 JP 141241/88**

(43) Date of publication of application:
**13.12.89 Bulletin  89/50**

(45) Publication of the grant of the patent:
**18.05.94 Bulletin  94/20**

(84) Designated Contracting States:
**DE FR GB**

(56) References cited:
**WO-A-89/01704**

**I.E.E.E. JOURNAL OF OUANTUM ELECTRON-ICS, vol. OE-22, no. 9, September 1986, pages 1900-1909, New York, US ; I. SUEMUNE et al. : "Gain-Switching Characteristics and Fast Transient Response of Three-Terminal Size-Effect Modulation Laser".**

**INTERNATIONAL ELECTRON DEVICES MEETING, WASHINGTON, DC, 1st-4th December 1985, pages 558-561, IEEE, New York, US ; D.A. ANTONIADIS et al. : "Ouantum mechanical effects in very short and very narrow channel MOSFETs".**

(73) Proprietor: **FUJITSU LIMITED
1015, Kamikodanaka
Nakahara-ku
Kawasaki-shi Kanagawa 211(JP)**

(72) Inventor: **Okada, Makoto
119-3-107, Shirane
Isehara-shi Kanagawa, 259-11(JP)**

(74) Representative: **Seeger, Wolfgang, Dipl.-Phys.
Georg-Hager-Strasse 40
D-81369 München (DE)**

JOURNAL OF VACUUM SCIENCE & TECH-
NOLOGY B, vol. 4, no. 1, January-February
1986, pages 365-368, Second Series, New
York, NY, US ; A.C. WARREN et al. : "Fabrica-
tion of sub-100 nm linewidth periodic struc-
tures for study of quantum effects from in-
terference and confinement in Si inversion
layers".

PROCEEDINGS OF THE I.E.E.E., vol. 75, no.
11, November 1987, pages 1472-1483, New
York, NY, US ; Y. SUEMATSU et al. : "In-
tegrated Optics Approach for Advanced
Semiconductor Lasers".

PATENT ABSTRACTS OF JAPAN, vol. 9266
(E-352), 23 October 1985 ; & JP-A-60 113 488

PHYSICAL REVIEW B, vol. 34, no. 8, 15 Octo-
ber 1986, pages 5635-5638, New York, US ;
H.Z. ZHENG et al. : "Gate-controlled trans-
port in narrow GaAs/A1xGa1-xAs.

ELECTRONIOUE INDUSTRIELLE, no. 32, 15
April 1982, pages 31-37, Paris, F ; E. CATIER :
"Liaisons longue distance par fibres opt-
iques 1,3 mikrometer et diodes laser".

## Description

## BACKGROUND OF THE INVENTION

The present invention generally relates to semiconductor devices and more particularly to an optical semiconductor device capable of producing or detecting an optical beam having a variable wavelength.

In a large capacity coherent telecommunication network in which a coherent optical beam is used as the medium for carrying information, optical semiconductor devices such as laser diode, light emitting diode, or photodiode are used for producing or detecting the optical beam. Modulation of the information on the optical beam is usually made by changing the amplitude of the optical beam or by interrupting the optical beam intermittently to form optical pulse.

In such a telecommunication network, it is frequently desired that the frequency or wavelength of the optical beam is variable. In doing so, one can modulate the information on the optical beam by changing its wavelength. Unfortunately, the wavelength of the optical beam produced by a laser diode is determined by energy gap in the active layer of the laser diode which is pertinent to the material forming the active layer. Thus, the commonly used laser diode is not capable of changing its oscillation wavelength.

In order to obtain a variable wavelength laser diode, it is proposed to use a distributed Bragg-reflection (DFR) laser having an oscillating part oscillating with a continuous spectrum coupled with a tunable resonant structure capable of being tuned to variable wavelengths. By tuning the resonant structure to a particular energy or wavelength, one can selectively amplify an optical beam having a desired wavelength. Such a resonant structure may be formed by a medium capable of changing its refractive index responsive to application of electrical voltage. A diffraction grating is formed in the medium such that there will be established a resonance when the Bragg condition is satisfied between the wavelength of the optical beam and the period of the diffraction grating.

In such a variable wavelength laser diode, however, there is a problem in that the extent the wavelength can be changed is limited because of the limited width in the oscillation spectrum of light emitted from the oscillating part. Thus, such a laser diode is not satisfactory for use in the aforementioned technical fields. Further, there is a problem in that the structure of the laser diode is complex and difficult to manufacture, as it is necessary to provide the tunable resonant structure carrying the diffraction grating separately to an oscillating part of the laser diode in which the active layer is contained.

Further, there is proposed another type of laser diode based on the distributed feedback (DFB) structure. In this type of laser diode, a similar resonant structure is provided in the active layer itself. Thus, when the wavelength of the optical beam satisfies the condition of Bragg reflection, there is established a resonance and the optical beam produced by the stimulated emission of photon is amplified. By changing the refractive index of the active layer, the wavelength of the optical beam satisfying the Bragg condition is changed and one can tune the resonant structure to another desired wavelength corresponding to higher order transition. In such a structure, there is a problem in that the wavelength can be changed only stepwise and that the structure of the laser diode becomes complex as it is necessary to provide diffraction grating in the active layer of the laser diode.

## SUMMARY OF THE INVENTION

Accordingly, it is a general object of the present invention to provide a novel and useful optical semiconductor device, wherein the aforementioned problems are eliminated.

Another and more specific object of the present invention is to provide an optical semiconductor device having a simple construction and yet capable of being tuned to various wavelengths.

Another object of the present invention is to provide an optical semiconductor device for producing or detecting an optical beam in which the wavelength of the optical beam can be changed continuously.

Another object of the present invention is to provide an optical semiconductor device comprising an active quantum well layer sandwiched by a pair of confinement layers, wherein there is provided a plurality of first electrode means extending parallel to each other on one of the confinement layers and an opposing second electrode means provided on the other confinement layer. According to the present invention, there is formed a plurality of depletion regions in the active layer in correspondence to each of the first electrode means when a control voltage is applied across the first and second electrode means. Such a depletion region defines an effective region having a limited width in the active layer, and the width of the effective region can be controlled by the control voltage applied to the electrode means. As the active layer itself has a limited thickness to form a quantum well structure, there is formed a quantum well wire in the active layer in correspondence to the effective region as a result of its reduced width. Responsive to the formation of the quantum well wire, there appear additional quantum levels for electrons and holes in the effective region. As the additional quantum levels thus formed change with the width of the quantum well wire which in turn can be controlled by the electrical voltage applied to the electrode means, one can change the wavelength of the optical beam interacting with the electron and hole in the active layer continuously.

Other objects and further features of the present invention will become apparent from the following detailed description when read in conjunction with attached drawings.

## DETAILED DESCRIPTION

FIGS.1(A) and (B) are diagrams showing an embodiment of the optical semiconductor device of the present invention in plan view and a longitudinal cross sectional view, respectively;

FIGS.2(A) and (B) are cross sectional views showing essential part of the device of FIG.1 in two different states;

FIG.3 is a diagram showing a band structure characteristic to a quantum well formed in the device of FIG.1;

FIGS.4(A) - (C) are diagrams showing band structure at various parts of the device of FIG.1;

FIG.5 is a graph showing the effect of dimension of a quantum well structure on the energy of transition in such a quantum well structure;

FIG.6 is a cross sectional view showing another embodiment of the optical semiconductor device of the present invention;

FIG.7 is a cross sectional view similar to FIG.6 showing another embodiment of the optical semiconductor device of the present invention;

FIG.8 is a cross sectional view similar to FIG.6 showing still another embodiment of the optical semiconductor device of the present invention; and

FIG.9 shows another embodiment of the optical semiconductor device of the present invention.

## DETAILED DESCRIPTION

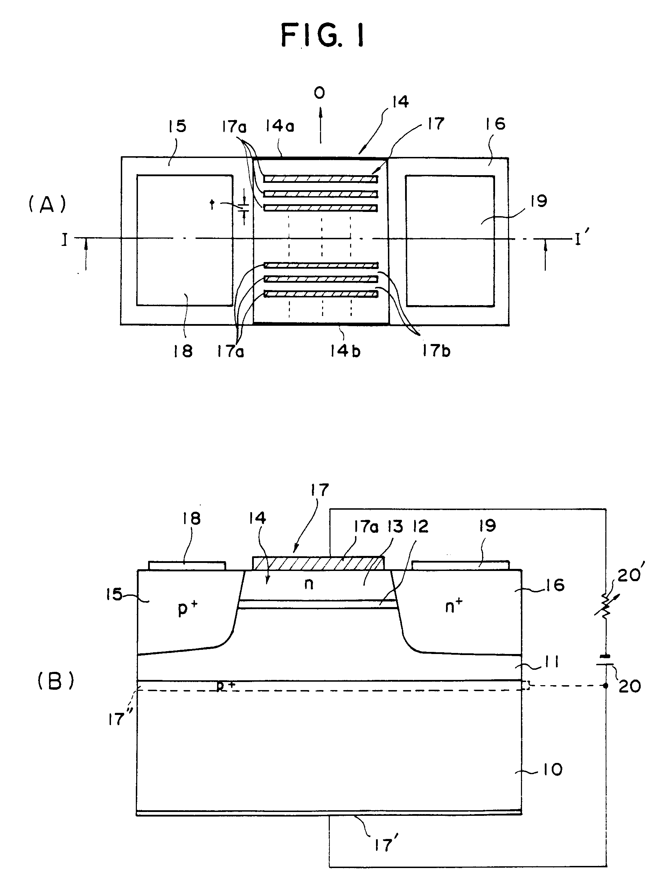

FIG.1(A) is a plan view of a first embodiment of the optical semiconductor device of the present invention. The device is a laser diode for producing an optical beam designated by an arrow $\underline{O}$ and comprises a mesa 14 formed with an active layer therein and a pair of conductive regions 15 and 16 provided on both sides of the mesa 14 for carrier injection. For this purpose, the conductive regions 15 and 16 are doped to the p⁺-type and the n⁺-type respectively and carry electrodes 18 and 19 to be connected to external drive source (not shown) for injecting carriers to an active layer 12 in FIG.1(B). The oscillation occurs in the active layer located inside the mesa 14. The front end and the rear end of the mesa are bounded by cleaved surfaces 14a and 14b which act as mirror forming the Farby-Pérot resonator.

FIG.1(B) is a longitudinal cross section of the device of FIG.1(A) taken along a I-I' line. Referring to the drawing, the laser diode is formed on an intrinsic type gallium arsenide (GaAs) substrate 10 on which a confinement layer 11 to be described is provided. The confinement layer 11 comprises an intrinsic type aluminium gallium arsenide (AlGaAs) layer having a maximum thickness of about 1.5 $\mu$m in a part corresponding to the mesa 14. The aforementioned conductive regions 15 and 16 are provided at both sides of this part of maximum thickness corresponding to the mesa 14. The conductive regions 15 and 16 comprises doped AlGaAs and is grown by liquid phase epitaxy (LPE) on the confinement layer 11 after the mesa 14 is formed by etching as will be described later. On the part of the confinement layer 11 corresponding to the mesa 14, there is provided the active layer 12 of intrinsic GaAs having a thickness of about 300 Å (10 Å = 1 nm). Further, another confinement layer 13 of AlGaAs is provided on the active layer 12 for a thickness of about 600 Å. The confinement layer 13 is doped to the n-type with a carrier level of about $1 \times 10^{18}$ cm⁻³. The function of this doped confinement layer 13 will be described later.

Further, an electrode structure 17 comprising a plurality of parallel electrodes 17a each having a width $\underline{t}$ of about 2000 Å is provided on the top of the confinement layer 13 with a mutual separation of about 500 Å, and a corresponding sheet electrode 17' is provided on the bottom of the substrate 10 so as to cover the bottom uniformly. Further, the gap formed between the adjacent electrodes 17a is filled by an insulator such as silica glass 17b. Each of the electrodes 17a is connected to a minus terminal of a d.c. voltage source 20 via a voltage regulator 20' and the electrode 17' is connected to a plus terminal of the voltage source 20. The electrodes 17a and 17' may be formed by sputtering of metal such as gold (Au) or aluminium (Al) which forms Schottky contact with the semiconductor layer underneath. Alternatively, one may provide a p⁺-type layer 17″ at a boundary between the substrate 10 and the confinement layer 11 and connect the layer 17″ to the plus terminal of the voltage source 20. As for the electrode 18, a conductor body forming ohmic contact with the conductive layers 15 and 16 such as the one comprising stacked layers of gold (Au) and a gold-zinc alloy (AuZn) may be used. As for the electrode 19, a conductor body comprising stacked layers of gold and a gold-germanium alloy (AuGe) also forming ohmic contact may be used. However, the material for the electrodes 18 and 19 is not limited to these materials as long as they make an ohmic contact with the semiconductor material underneath.

The structure illustrated in FIG.1 may be formed by first growing the semiconductor layers 10, 11, 12 and 13 successively by well known molecular beam epitaxy (MBE) technique or by metal-organic chemical vapor deposition (MOCVD) technique. After doping of the layer 13 to the n-type, the part corresponding to the conductive regions 15 and 16 are removed by etching which may be a wet etching performed by using a hydrofluoric solution containing hydrogen peroxide. Then the conductive regions 15 and 16 are grown by LPE as already described. After the doping of the conductive regions 15 and 16 to the $p^+$- and $n^+$-type, the electrodes 17a, 17′, 18 and 19 are provided by sputtering. The formation of the electrode structure 17 may be made as follows. First, a silica glass layer (not shown) is deposited on the top of the confinement layer 13 uniformly. Next, a photoresist (not shown) is deposited on the silica glass layer and the photoresist is patterned by an interference of a laser beam produced by a helium-cadmium (He-Cd) laser. With this, the photoresist is exposed according to the stripe-shaped pattern of the electrode 17a. After the patterning of the photoresist, the silica glass layer is removed selectively so as to expose the surface of the confinement layer 13 according to the pattern on the electrode 17a, and the aforementioned material forming the electrode is deposited thereon. Further, the electrodes 18 and 19 are provided on the conductive regions 15 and 16.

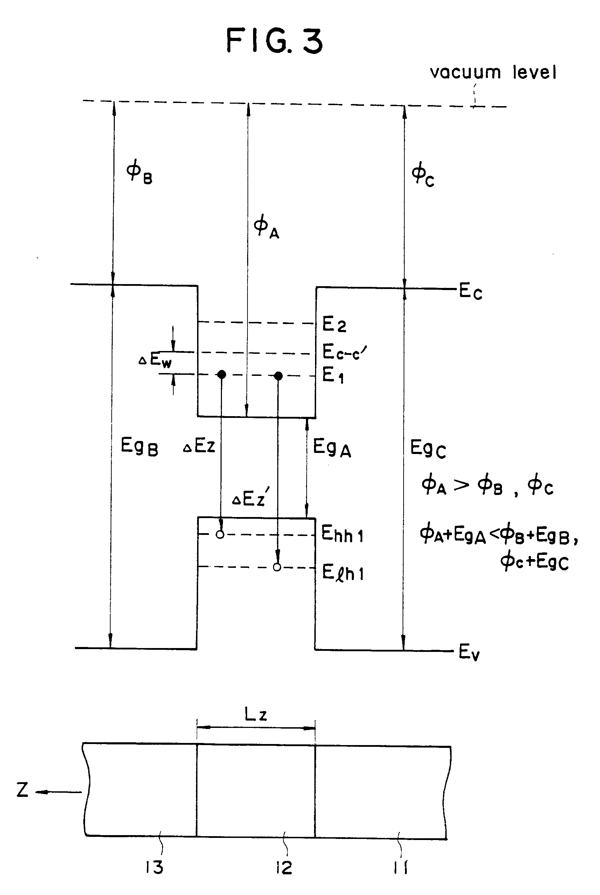

Next, the operation of the laser diode of FIG.1 will be described. As already described, the active layer 12 bounded by the confinement layers 11 and 13 has a thickness of about 300 Å. Further, the confinement layers 11 and 13 made of AlGaAs has a band gap much larger than that of GaAs forming the active layer 12. In such a structure where a very thin active layer is sandwiched between a pair of confinement layers having a large band gap, there is formed a quantum well which is schematically illustrated in FIG.3. It should be noted that the conductive regions 15 and 16 also have a similar band structure. However, the regions 15 and 16 do not contribute to the formation of the quantum well as the distance between the conductive layers 15 and 16 across the mesa 14 is much larger than the thickness of the active layer 12.

Referring to FIG.3, the active layer 12 having a limited thickness represented as Lz has a band gap $Eg_A$ which is substantially smaller than the band gap $Eg_B$ or $Eg_C$ of the confinement layers 11 and 13. Further, the level of the conduction band Ec of the layer 12 is lower than the level of the conduction band Ec of the layers 11 and 13. This relation may be represented in terms of electron affinity such that the electron affinity $\phi_A$ representing the level of the conduction band Ec of the layer 12 measured with reference to a vacuum level is larger than the electron affinity $\phi_B$ or $\phi_C$ for the layer 11 or 13. In other words, there holds a relation

$$\phi_A > \phi_B, \phi_C.$$

Further, the level of the valence band Ev of the active layer 12 is larger than those of the confinement layers 11 and 13 which is represented as

$$\phi_A + Eg_A < \phi_B + Eg_B, \phi_C + Eg_C$$

In such a quantum well structure, electron or hole injected to the active layer 12 from the conductive regions 15 or 16 is confined between the layers 11 and 13 as well as between the conductive regions 15 and 16 and the luminous efficiency is improved. In a quantum well structure, it is known that there appears discrete quantum levels for electron and hole. Thus, discrete quantum levels E1, E2, ... for electron are formed above the conduction band Ec in which the level E1 corresponds to the ground state. Similarly, there appear discrete quantum levels $E_{hh1}$, $E_{lh1}$, ... for holes. The level $E_{hh1}$ is for the heavy hole and the level $E_{lh1}$ is for the light hole. Both of them corresponds to the ground state. The recombination of electron and hole causing emission of photon or transition of electron responsive to optical irradiation takes place between these discrete quantum levels. The wavelength of the emitted or absorbed light is determined by the energy difference between these discrete quantum levels.

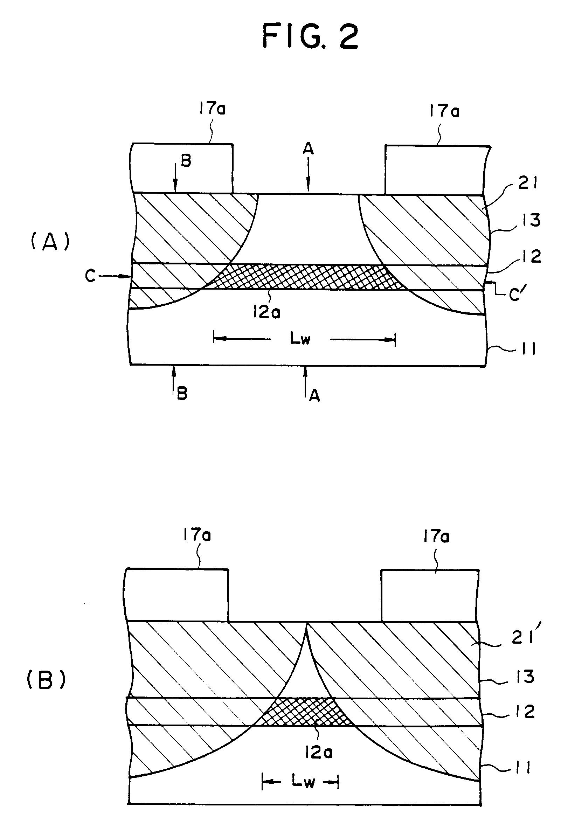

It should be noted that, in the laser diode of the present invention, the metal electrode 17a is directly contacted to the n-type confinement layer 13 as illustrated in FIG.1(B). At a junction where metal is contacted with such a semiconductor material, there is formed a Schottky barrier which causes depletion of electron in the region of the semiconductor material contacting with the metal. Thus, there is formed a depletion region 21 adjacent to the electrode 17a in the n-type confinement layer 13 in which electron is expelled from the confinement layer 13 by the Schottky barrier as shown in FIG.2(A). It should be noted that such a depletion region 21 extends into the active layer 12 and further into the other confinement layer 11 beyond the layer 13. When such a depletion region 21 is formed, electron can exist only in a limited region 12a of the active layer 12 defined by a pair of depletion regions 21. Such a region 12a will be referred to hereinafter as "effective region". The effective region 12a has a width Lw which is determined by the extension of the pair of depletion regions 21 at both sides. When the width Lw is extremely limited, there is formed a quantum well wire. In such a quantum well wire, there is formed further additional quantum levels such as $E_{c-c}$, for electron at a level above the quantum level E1 as illustrated in FIG.3. In such a quantum well wire, the emission or absorption of photon is caused as a result of recombination or transition across such additional quantum levels.

It should be noted that the additional quantum level $E_{c-c}$, is changed in accordance with the width Lw of the quantum well. This width Lw of the quantum well is changed responsive to the degree of extension of the depletion region 21 towards the confinement layer 11 beyond the active layer 12 which in turn can be controlled by changing the electrical voltage applied across the electrodes 17a and 17′. FIG.2(B) shows a state in which an increased negative voltage is applied to the electrode 17a. It can be seen that the width Lw of the effective active region 12a is reduced substantially. Responsive thereto, the wavelength of the light emitted by the recombination of electron and hole is changed. With increasing magnitude of the voltage across the electrodes 17a and 17′, the width Lw is reduced and the energy level of the quantum level $E_{c-c}$, increases which in turn causes decrease in the wavelength of the emitted light. A similar relation holds also at the time of absorption of light.

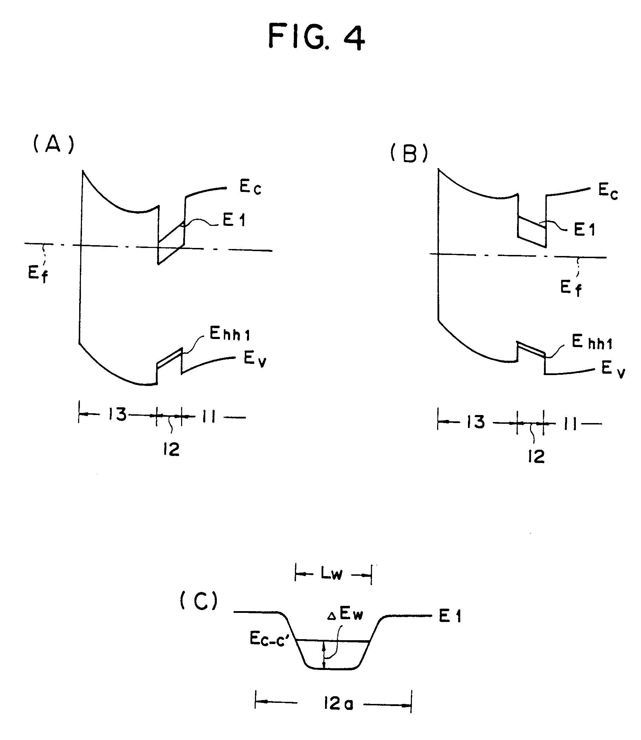

FIGS.4(A) - (C) show band structure along various sections of the laser diode of FIG.1 in which FIG.4(A) represents the band structure for a section taken along an A-A line of FIG. 2(A), FIG.4(B) represents the band structure for a section taken along a B-B line of FIG.2(A), and FIG.4(C) represents the band structure for a section along a C-C line of FIG. 2(A), respectively. It should be noted that FIG. 4(A) views a part where no depletion region is formed while FIG.4(B) views a part where the depletion region 21 is formed. It can be seen that the energy bands Ec and Ev for the confinement layer 13 is raised in the cross section of FIG.4(B) relative to that of FIG.4(A). Further, it can be seen that the quantum level E1 is formed above the conduction band Ec in correspondence to the quantum well structure. This quantum level E1 is lowered or depressed in correspondence to the effective active region 12a forming the quantum well wire as can be seen in FIG.4(C) which shows the change of the quantum level E1 along a C-C line shown in FIG.4(A). In this depressed part of the quantum level E1, there is formed the quantum level $E_{c-c}$, for the quantum well wire at a level separated upwards from E1 by an energy difference of $\Delta E_w$. It is this energy difference $\Delta E_w$ which is actually changed responsive to the change in the width Lw of the effective active region 12a.

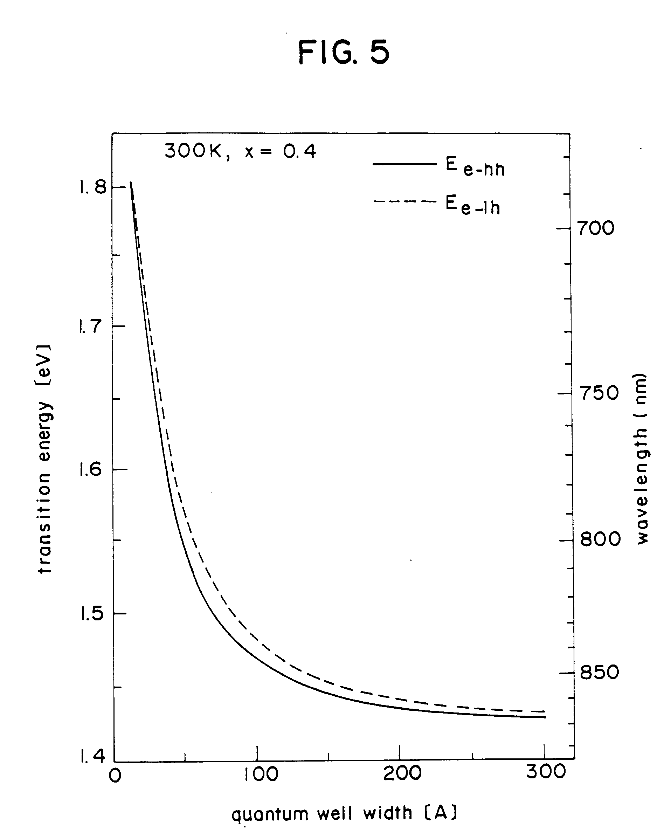

FIG.5 is a graph presented to show the general tendency of change in the energy difference $\Delta E_w$

with the width Lw in analogy with the corresponding relation for the case of quantum well. Thus, FIG.5 actually shows the change in the energy of transition of a quantum well as a function of the thickness $\underline{L}$ of the quantum well. It should be noted that this relation itself is known. In the drawing, the solid line represents the energy of transition of electron to a heavy hole level and the broken line represents the energy of transition to a light hole level. This change in the transition energy is for a quantum well of GaAs bounded by a pair of confinement layers of $Al_{0.4}Ga_{0.6}As$. As can be seen in the drawing, the transition energy changes with the thickness $\underline{L}$ in which the change in the energy is small in a region of large quantum well thickness while the change in the energy becomes increasingly large with the reduced thickness of the quantum well. Although this known result is for the ordinary quantum well and not for the quantum well wire, a same effect is also observed in the case of the quantum well wire. In other words, the change in the energy difference $\Delta E_w$ responsive to the change in the width Lw of the quantum well wire becomes increasingly larger with decrease in the width Lw. Thus, the control of the wavelength of the optical beam by the control of the width Lw of the effective region 12a becomes increasingly effective with reduced width Lw. In order to obtain an effective control of the wavelength, a width of less than about 1000 Å is preferred for the width Lw. In the laser diode of the present embodiment, the wave length can be changed as much as 25 nm by the change of Lz from 300 Å to 100 Å. This change in the wavelength corresponds to a frequency change of about 10 THz.

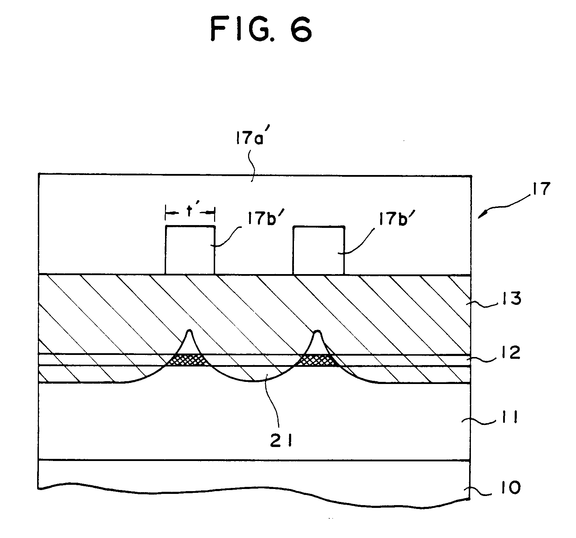

Next a second embodiment of the optical semiconductor device of the present invention will be described with reference to FIG.6. This device is also a laser diode and these parts constructed identically to those corresponding parts of the preceding drawings are given identical reference numerals and the description thereof will be omitted.

In this embodiment, the electrode structure 17 comprises a sheet electrode 17a′ covering the top surface of the mesa 14 and a plurality of elongated insulator regions 17b′ of silica glass extending parallel to each other throughout the sheet electrode 17a′ along the boundary between the electrode 17a′ and the layer 13. The insulator region 17b′ extends in a direction perpendicular to the direction of propagation of the light beam $\underline{O}$. The region 17b′ has a width t′ corresponding to the separation between a pair of the electrodes 17a of the first embodiment and may be 500 Å, for example. Further, the separation between the adjacent regions 17′ may be chosen to 2000 Å in correspondence to the thickness $\underline{t}$ of the first embodiment. Thus, the arrangement of conductor and insulator in the electrode structure of FIG.6 is complementary to that of the electrode structure of FIG.1. Such an electrode structure may be formed similarly to the case of the first embodiment.

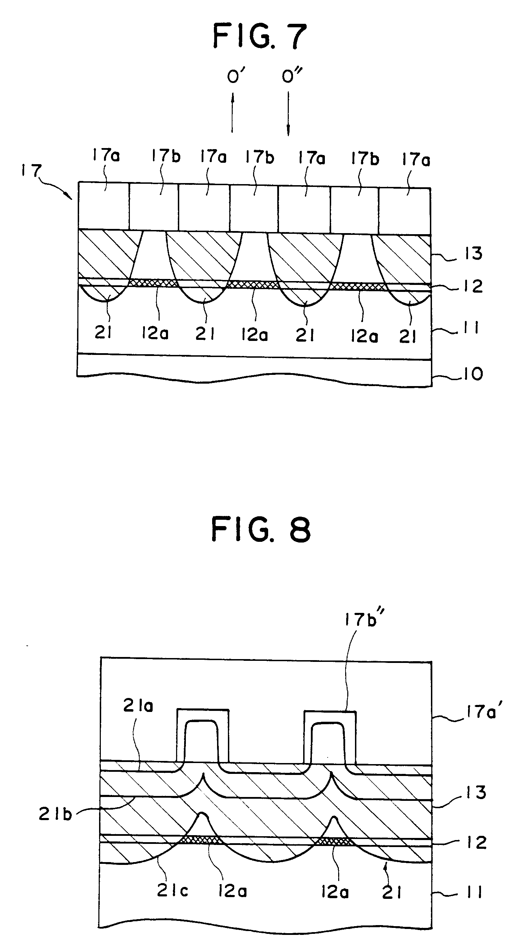

Next, a third embodiment of the optical semiconductor device of the present invention will be described with reference to FIG.7. In the drawing, those parts constructed identically to those corresponding parts in the preceding drawings are given identical reference numerals and the description thereof will be omitted.

In this embodiment, the structure inside the mesa 14 is identical except that the front end and rear end of the mesa 14 are not cleaved to form mirror surfaces 14a and 14b. Thus, the device operates as a light emitting diode or photodiode. In the drawing it can be seen that there are a plurality of electrodes 17a and a plurality of effective regions 12a formed in correspondence to the electrodes 17a. The emission of light is caused similarly to the case of the laser diode of FIG.1 responsive to the injection of carrier from the electrodes 18 and 19. The light produced in the active layer 12 is radiated to the outside through the silica glass layer 17b acting as a window as a light O′. Use of transparent electrode such as indium tin oxide (ITO) further improves the operation of the device. When to operate the device as the photodiode, an electrical current is obtained from the electrodes 18 and 19 responsive to the excitation of electron which in turn is caused responsive to the irradiation of the active layer 12 by an incident light beam O″ through the window 17b. Similarly to the case of the first embodiment, one can change the wavelength of the light which interacts with such transition of electron in the active layer by changing the voltage applied to the electrodes 18 and 19.

FIG.8 shows a fourth embodiment of the optical semiconductor device of the present invention. In the drawing, these parts constructed identically to those corresponding parts in the preceding drawings are given identical reference numerals and the description thereof will be omitted.

In this embodiment, the elongated insulator region 17b′ of the second embodiment is replaced by a cap layer 17b″ of GaAs doped to the n-type. The cap layer 17b″ has a carrier concentration level of about $1 \times 10^{18}$ cm$^{-3}$ and has a thickness measured perpendicularly to the plane of the layer 13 of about 300 Å. Thus, the electrode 17a′ bridges the both sides of the cap layer 22.

In such an electrode structure, the depletion region 21 is formed continuously from the n-type AlGaAs confinement layer 13 to the cap layer 17b″. Thus, responsive to the gradual increase in the voltage applied to the electrode 17a′, the depletion region 21 extends gradually towards the layer 11 as shown by lines 21a, 21b and 21c. Thus, the depletion region thus formed has a shape similar to the shape of the depletion region 21 in FIG.1(A) and defines the effective region 12a as already described. The width of the region 12a can of course be controlled by the voltage applied across the electrode 17a′ and the corresponding electrode 17′. By using the cap layer 22 instead of the silica glass region 17b′, problems associated with various interface states formed at the boundary between the silica region 17b′ and the n-type AlGaAs layer 13 on the depletion layer is avoided. Thus, the characteristic of the device is improved.

In all of the embodiments described heretofore, it should be noted that the optical semiconductor device can be made as laser diode by providing the mirrors 14a and 14b and as photodiode or light emitting diode by removing the mirrors.

The material for the active layer 12 or the confinement layer 11 or 13 is not limited to the material described but any other material having a conduction band and valence band satisfying the relation shown in FIG.3 may be used. Further, the structure of the semiconductor is not limited the so-called SQW (single quantum well) structure described above but may be a multiple quantum well structure or may be a graded layer structure. Further a super lattice structure may be used for the formation of the quantum well.

Furthermore, the radiation used for the patterning of the electrode 17a in the electrode structure 17 is not limited to the He-Cd laser radiation but any other radiation such as synchrotron orbital radiation or any other suitable radiation may be used. Further, by using the present optical semiconductor device as a light receiving element capable of changing its operational wavelength responsive to application of external voltage, one can easily construct a spectrum analyzer.

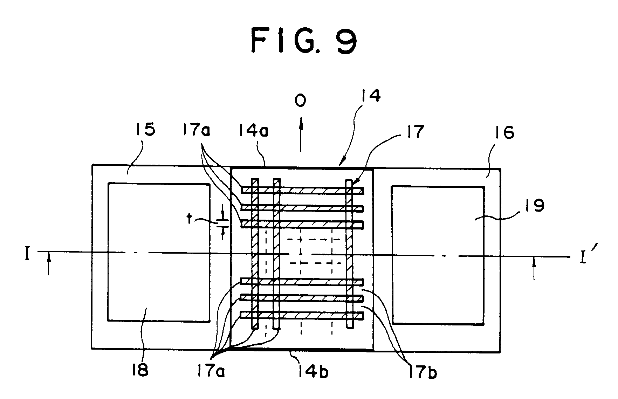

FIG.9 shows another embodiment of the optical semiconductor device of the present invention in which the electrode structure 17 is constructed by a plurality of electrodes 17a′ arranged in a form of lattice. In this embodiment, there is formed a depletion region having a lattice form which defines a quantum well box. In such a configuration, too, the energy of transition of electron at the time of photon emission can be changed continuously by applying variable voltage to the electrodes 17a′. As the operation of the device is substantially identical to the operation of the device described previously, further description of the device will be omitted.

## Claims

1. A tunable light emitting device for producing a light having a variable wavelength, comprising an active layer (12) of an intrinsic type semiconductor material having a thickness such as to allow the formation of a quantum well, said active layer being injected with carriers and producing light by the recombination of said carriers, first and second conductive regions (15, 16) provided so as to bound the active layer laterally on the right and on the left for injecting the carriers in the active layer, said first and second conductive regions comprising a doped semiconductor material of a first and a second conductivity type respectively, first and second electrode means (18, 19) provided on said first and second conductive regions respectively so as to make ohmic contact therewith for connection to external driving source, characterized by first and second confinement layers (13, 11) provided parallel to said active layer so as to sandwich the active layer from above and below for confining the carriers in the active layer, said first and second confinement layers comprising a semiconductor material having a band gap (EgB, EgC) substantially larger than that (EgA) of the active layer, third electrode means (17) provided on said first confinement layer such that there is formed a depletion region (21) in the active layer underneath the first confinement layer in correspondence to the third electrode means, said third electrode means being configured such that a plurality of depletion regions are formed in the active layer which define at least one region (12a) of the active layer located between at least a pair of depletion regions, said at least one region having a modified energy level of electrons, fourth electrode means (17', 17") provided in correspondence to the third electrode means so as to face the third electrode means across the second confinement layer, and biasing means (20, 20') for applying a variable voltage across the third and fourth electrode means so as to control extension of the depletion region into the active layer, thereby controlling the wavelength of the emitted light.

2. A device as claimed in claim 1 characterized in that the semiconductor material forming said first and second confinement layers (13, 11) has a conduction band (Ec) and a valence band (Ev) wherein a bottom edge of the conduction band and a top edge of the valence band respectively have energies higher and lower than corresponding edges of corresponding bands of the semiconductor material forming the active layer (12).

3. A device as claimed in claim 1 or 2 characterized in that said active layer (12) comprises gallium arsenide, and said first and second confinement layers (13, 11) comprise aluminium gallium arsenide.

4. A device as claimed in claim 1 characterized in that said third electrode means (17) comprises a plurality of elongated electrodes (17a) extending parallel to each other.

5. A device as claimed in claim 4 characterized in that said plurality of parallel elongated electrodes (17a) are separated from one another by 100 nm or less.

6. A device as claimed in claim 1 characterized in that said third electrode means (17) comprises a sheet electrode (17a') provided on said first confinement layer (13), and said sheet electrode is formed with a plurality of elongated regions (17b') of insulator extending parallel to each other along the first confinement layer.

7. A device as claimed in claim 6 characterized in that said insulator comprises silica glass.

8. A device as claimed in claim 1 characterized in that there is provided reflection means (14a, 14b) at front and rear sides of the active layer (12).

9. A device as claimed in claim 8 characterized in that said reflection means (14a, 14b) comprises a cleaved surface.

10. A photodiode for sensing light of variable wavelengths, comprising an active layer (12) for producing carriers in response to irradiation by the light, said active layer comprising an intrinsic type semiconductor material and having a thickness such as to allow the formation of quantum well therein, first and second conductive regions (15, 16) provided so as to bound the active layer laterally on the right and on the left, said first and second conductive regions comprising a semiconductor material of a first and a second conductivity type respectively so as to collect the carriers from the active layer, first and second electrode means (18, 19) provided on said first and second conductive regions respectively so as to make ohmic contact therewith for producing electrical current responsive to the carrier collected in the first and second conductive regions from the active layer, characterized by first and second confinement layers (13, 11) provided parallel to said active layer so as to sandwich the active layer from above and below for confining the carriers in the active layer, said first and second confinement layers comprising a semiconductor material having a band gap (EgB, EgC) substantially larger than that (EgA) of the semiconductor material of the active layer, third electrode means (17) provided on said first confinement layer such that there is formed a depletion region (21) in the active layer underneath the first confinement layer in correspondence to the third electrode means, said third electrode means being configured such that a plurality of depletion regions are formed in the active layer which define at least one region (12a) of the active layer located between at least a pair of depletion regions, said at least one region having a modified energy level of electrons, fourth electrode means (17', 17") provided in correspondence to the third electrode means so as to face the third electrode means across the first confinement layer, active layer and the second confinement layer, and biasing means (20, 20') for applying a variable voltage across the third and fourth electrode means so as to control extension of the depletion region into the active layer, thereby controlling the wavelength of the light absorbed therein.

**Patentansprüche**

1. Abstimmbare lichtemittierende Anordnung zur Erzeugung eines Lichts mit variabler Wellenlänge, mit einer aktiven Schicht (12) aus einem Halbleitermaterial vom eigenleitenden Typ mit einer Dicke, um die Bildung einer Quantenmulde zu ermöglichen, wobei die genannte aktive Schicht mit Trägern injiziert wird und durch die Rekombination der genannten Träger Licht erzeugt, einer ersten und zweiten leitenden Zone (15, 16), die vorgesehen sind, um die aktive Schicht lateral rechts und links zum Injizieren der Träger in die aktive Schicht zu begrenzen, wobei die genannte erste und zweite leitende Zone ein dotiertes Halbleitermaterial von einem ersten bzw. einem zweiten Leitfähigkeitstyp umfassen, einer ersten und zweiten Elektrodeneinrichtung (18, 19), die an der genannten ersten bzw. zweiten leitenden Zone vorgesehen sind, um einem ohmschen Kontakt damit für eine Verbindung mit einer externen Antriebsquelle herzustellen, gekennzeichnet durch eine erste und zweite Begrenzungsschicht (13, 11), die parallel zur genannten aktiven Schicht vorgesehen sind, um die aktive Schicht von oben und unten zum Begrenzen der Träger in der aktiven Schicht sandwichartig anzuordnen, wobei die genannte erste und zweite Begrenzungsschicht ein Halbleitermaterial mit einer Bandlücke (EgB, EgC), die wesentlich größer ist als jene (EgA) der aktiven Schicht, umfassen, einer dritten Elektrodeneinrichtung (17), die an der genannten ersten Begrenzungsschicht vorgesehen ist, so daß eine Verarmungszone (21) in der aktiven Schicht unter der ersten Begrenzungsschicht entsprechend der dritten Elektrodeneinrichtung gebildet wird, welche dritte Elektrodeneinrichtung derart konfiguiert ist, daß eine Vielzahl von Verarmungszonen in der aktiven Schicht gebildet wird, die zumindest eine Zone (12a) der aktiven Schicht, die zwischen zumindest einem Paar von Verarmungszonen angeordnet ist, definieren, wobei die genannte zumindest eine Zone ein modifiziertes Energieniveau der Elektronen aufweist, einer vierten Elektrodeneinrichtung (17', 17"), die entsprechend der dritten Elektrodeneinrichtung vorgesehen ist, um der dritten Elektrodeneinrichtung quer über der zweiten Begrenzungsschicht zugewandt zu sein, und einer Vorspanneinrichtung (20, 20') zum Anlegen einer variablen Spannung quer über der dritten und vierten Elektrodeneinrichtung, um die Ausweitung der Verarmungszone in die aktive Schicht zu steuern, wodurch die Wellenlänge des emittierten Lichts gesteuert wird.

2. Anordnung nach Anspruch 1, dadurch gekennzeichnet, daß das die genannte erste und zweite Begrenzungsschicht (13, 11) bildende Halbleitermaterial ein Leitungsband (Ec) und ein Valenzband (Ev) aufweist, wobei ein unterer Rand des Leitungsbandes bzw. ein oberer Rand des Valanzbandes Energien haben, die höher und niedriger als die entsprechenden Ränder entsprechender Bänder des die aktive Schicht (12) bildenden Halbleitermaterials sind.

3. Anordnung nach Anspruch 1 oder 2, dadurch gekennzeichnet, daß die genannte aktive Schicht (12) Galliumarsenid umfaßt, und die genannte erste und zweite Begrenzungsschicht (13, 11) Aluminiumgalliumarsenid umfassen.

4. Anordnung nach Anspruch 1, dadurch gekennzeichnet, daß die genannte dritte Elektrodeneinrichtung (17) eine Vielzahl von länglichen Elektroden (17a), die parallel zueinander verlaufen, umfaßt.

5. Anordnung nach Anspruch 4, dadurch gekennzeichnet, daß die genannte Vielzahl paralleler länglicher Elektroden (17a) durch 100 nm oder weniger voneinander getrennt ist.

6. Anordnung nach Anspruch 1, dadurch gekennzeichnet, daß die genannte dritte Elektrodeneinrichtung (17) eine Blattelektrode (17a'), die an der genannten ersten Begrenzungsschicht (13) vorgesehen ist, umfaßt, und die genannte Blattelektrode mit einer Vielzahl länglicher Zonen (17b') aus einem Isolator, die parallel zueinander entlang der ersten Begrenzungsschicht verlaufen, gebildet ist.

7. Anordnung nach Anspruch 6, dadurch gekennzeichnet, daß der Isolator Silikaglas umfaßt.

8. Anordnung nach Anspruch 1, dadurch gekennzeichnet, daß eine Reflexionseinrichtung (14a, 14b) an der Vorder- und Rückseite der aktiven Schicht (12) vorgesehen ist.

9. Anordnung nach Anspruch 8, dadurch gekennzeichnet, daß die genannte Reflexionseinrichtung (14a, 14b) eine gespaltene Fläche aufweist.

10. Photodiode zum Fühlen von Licht mit variablen Wellenlängen, mit einer aktiven Schicht (12) zur Erzeugung von Trägern ansprechend auf die Einstrahlung des Lichts, wobei die genannte aktive Schicht ein Halbleitermaterial vom eigenleitenden Typ und mit einer Dicke, um die Bildung einer Quantenmulde darin zu ermöglichen, umfaßt, einer ersten und zweiten leitenden Zone (15, 16), die vorgesehen sind, um die aktive Schicht lateral rechts und links zu begrenzen, wobei die genannte erste und zweite leitende Zone ein Kalbleitermaterial von einem ersten bzw. einem zweiten Leitfähigkeitstyp umfassen, um die Träger von der aktiven Schicht zu sammeln, einer ersten und zweiten Elektrodeneinrichtung (18, 19), die an der genannten ersten bzw. zweiten leitenden Zone vorgesehen sind, um einem ohmschen Kontakt damit zur Erzeugung von elektrischem Strom ansprechend auf den in der ersten und zweiten leitenden Zone von der aktiven Schicht gesammelten Träger herzustellen, gekennzeichnet durch eine erste und zweite Begrenzungsschicht (13, 11), die parallel zur genannten aktiven Schicht vorgesehen sind, um die aktive Schicht von oben und unten zum Begrenzen der Träger in der aktiven Schicht sandwichartig anzuordnen, wobei die genannte erste und zweite Begrenzungsschicht ein Halbleitermaterial mit einer Bandlücke (EgB, EgC), die wesentlich größer ist als jene (EgA) des Halbleitermaterials der aktiven Schicht, umfassen, einer dritten Elektrodeneinrichtung (17), die an der genannten ersten Begrenzungsschicht vorgesehen ist, so daß eine Verarmungszone (21) in der aktiven Schicht unter der ersten Begrenzungsschicht entsprechend der dritten Elektrodeneinrichtung gebildet wird, wobei die genannte dritte Elektrodeneinrichtung derart konfiguriert ist, daß eine Vielzahl von Verarmungszonen in der aktiven Schicht gebildet wird, die zumindest eine Zone (12a) der aktiven Schicht, die zwischen zumindest einem Paar von Verarmungszonen angeordnet ist, definieren, wobei die genannte zumindest eine Zone ein modifiziertes Energieniveau der Elektronen aufweist, einer vierten Elektrodeneinrichtung (17', 17''), die entsprechend der dritten Elektrodeneinrichtung vorgesehen ist, um der dritten Elektrodeneinrichtung quer über der ersten Begrenzungsschicht, aktiven Schicht und der zweiten Begrenzungsschicht zugewandt zu sein, und einer Vorspanneinrichtung (20, 20') zum Anlegen einer variablen Spannung quer über der dritten und vierten Elektrodeneinrichtung, um die Ausweitung der Verarmungszone in die aktive Schicht zu steuern, wodurch die Wellenlänge des darin absorbierten Lichts gesteuert wird.

**Revendications**

1. Dispositif émetteur de lumière accordable pour produire un rayon lumineux ayant une longueur d'onde variable, comprenant : une couche active (12) d'une matière semi-conductrice du type intrinsèque ayant une épaisseur propre à permettre la formation d'un puits quantique, des porteurs étant injectés dans ladite couche active et celle-ci produisant de la lumière par la recombinaison desdits porteurs ; des première et seconde régions conductrices (15, 16) disposées de manière à limiter la couche active latéralement à droite et à gauche pour injecter des porteurs dans la couche active, lesdites première et seconde régions conductrices comprenant une matière semi-conductrice dopée, respectivement d'un premier et d'un second type de conductivité ; des premier et second moyens formant électrodes (18, 19) disposés, respectivement, sur lesdites première et seconde régions conductrices de manière à réaliser avec elles un contact ohmique pour connexion à une source de commande externe ; caractérisé par des première et seconde couches de confinement (13, 11) disposées parallèlement à ladite couche active de manière à prendre en sandwich, ladite couche active par-dessus et par-dessous pour confiner les porteurs dans la couche active, lesdites première et seconde couches de confinement comprenant une matière semi-conductrice ayant une bande interdite (Eg$_B$, Eg$_C$) sensiblement plus grande que celle (Eg$_A$) de la couche active ; un troisième moyen formant électrode (17) disposé sur ladite première couche de confinement de manière telle que soit formée une région appauvrie (21) dans la couche active située sous la première couche de confinement, en correspondance avec le troisième moyen formant électrode, ledit troisième moyen formant électrode étant conformé de telle manière qu'une pluralité de régions appauvries se forment dans la couche active ce qui définit au moins une région (12a) de la couche active située entre au moins une paire de régions appauvries, ladite au moins une région ayant un niveau d'énergie d'électrons modifié ; un quatrième moyen formant électrode (17', 17'') disposé en correspondance avec le troisième moyen formant électrode de manière à faire face au troisième moyen formant électrode à travers la seconde couche de confinement ; et un moyen de polarisation (20, 20') pour appliquer une tension variable aux bornes des troisième et quatrième moyens formant électrodes de façon à commander l'étendue de la région appauvrie à l'intérieur de la couche active, en commandant ainsi la longueur d'onde de la lumière émise.

2. Dispositif selon la revendication 1, caractérisé en ce que la matière semi-conductrice formant lesdites première et seconde couches de confinement (13, 11) présentent une bande de conduction (Ec) et une bande de valence (Ev) dans lesquelles le bord inférieur de la bande de conduction et le bord supérieur de la bande de valence ont des énergies, respectivement, plus élevées et plus faibles que les bords correspondants des bandes correspondantes de la matière semi-conductrice formant la couche active (12).

3. Dispositif selon la revendication 1 ou 2, caractérisé en ce que ladite couche active (12) comprend de l'arséniure de gallium, et en ce que lesdites première et seconde couches de confinement (13, 11) comprennent de l'arséniure d'aluminium et de gallium.

4. Dispositif selon la revendication 1, caractérisé en ce que le troisième moyen formant électrode (17) comprend une pluralité d'électrodes allongées (17a) s'étendant parallèlement les unes aux autres.

5. Dispositif selon la revendication 4, caractérisé en ce que les électrodes allongées parallèles (17a) de ladite pluralité sont écartées les unes des autres de 100 nm, ou moins.

6. Dispositif selon la revendication 1, caractérisé en ce que ledit troisième moyen formant électrode (17) comprend une électrode feuille (17a') disposée sur ladite première couche de confinement (13), et en ce que ladite électrode en feuille est formée d'une pluralité de régions isolantes allongées (17b') s'étendant parallèlement les unes aux autres le long de la première couche de confinement.

7. Dispositif selon la revendication 6, caractérisé en ce que ledit isolant comprend du verre de silice.

8. Dispositif selon la revendication 1, caractérisé en ce qu'il est prévu un moyen réfléchissant (14a, 14b) au droit des côtés avant et arrière de la couche active (12).

9. Dispositif selon la revendication 8, caractérisé en ce que ledit moyen réfléchissant (14a, 14b) comprend un plan de clivage.

10. Photodiode pour détecter de la lumière de longueurs d'ondes variables comprenant une couche active (12) pour produire des porteurs en réponse à l'éclairement par la lumière, ladite couche active comprenant une matière semi-conductrice du type intrinsèque et ayant une épaisseur propre à y permettre la formation de puits quantique ; des première et seconde régions conductrices (15, 16) disposées de manière à limiter la couche active latéralement à droite et à gauche, lesdites première et seconde régions conductrices comprenant une matière semi-conductrice, respectivement, d'un premier et d'un second type de conductivité, de manière à collecter les porteurs provenant de la couche active ; des premier et second moyens formant électrodes (18, 19) disposés, respectivement, sur lesdites première et seconde régions conductrices de manière à réaliser avec elles un contact ohmique pour produire un courant électrique sensible aux porteurs collectés dans les première et seconde régions conductrices et provenant de la couche active ; caractérisée par des première et seconde couches de confinement (13, 11) disposées parallèlement à ladite couche active de manière à prendre en sandwich, ladite couche active par-dessus et par-dessous pour confiner les porteurs dans la couche active, lesdites première et seconde couches de confinement comprenant une matière semi-conductrice ayant une bande interdite (Eg_B, Eg_C) sensiblement plus grande que celle (Eg_A) de la matière semi-conductrice de la couche active ; un troisième moyen formant électrode (17) disposé sur ladite première couche de confinement de manière telle que soit formée une région appauvrie (21) dans la couche active située sous la première couche de confinement, en correspondance avec le troisième moyen formant électrode, ledit troisième moyen formant électrode étant conformé de telle manière qu'une pluralité de régions appauvries se forment dans la couche active ce qui définit au moins une région (12a) de la couche active située entre au moins une paire de régions appauvries, ladite au moins une région ayant un niveau d'énergie d'électrons modifié ; un quatrième moyen formant électrode (17', 17'') disposé en correspondance avec le troisième moyen formant électrode de manière à faire face au troisième moyen formant électrode à travers la première couche de confinement, la couche active et la seconde couche de confinement ; et un moyen de polarisation (20, 20') pour appliquer une tension variable aux bornes des troisième et quatrième moyens formant électrodes de façon à commander l'étendue de la région appauvrie à l'intérieur de la couche active, en commandant ainsi la longueur d'onde de la lumière qui y est absorbée.

# FIG. 1

(A)

(B)

EP 0 345 626 B1

# FIG. 2

(A)

(B)

14

# FIG. 3

$\phi_A > \phi_B , \phi_C$

$\phi_A + Eg_A < \phi_B + Eg_B,$
$\phi_C + Eg_C$

# FIG. 4

(A)

(B)

(C)

# FIG. 5

# FIG. 6

# FIG. 7

# FIG. 8

# FIG. 9